# EUROPÄISCHE PATENTSCHRIFT

(11) **EP 1 451 014 B1**
(45) Veröffentlichungstag und Bekanntmachung des Hinweises auf die Patenterteilung: **14.01.2015**
(21) Anmeldenummer: 02792765.6
(22) Anmeldetag: 15.11.2002
(51) Int. Cl.: B41C 1/05, B41N 1/12, G03F 7/033

(54) **LASERGRAVIERBARE FLEXODRUCKELEMENTE ZUR HERSTELLUNG VON FLEXODRUCKFORMEN ENTHALTEND MISCHUNGEN AUS HYDROPHILEN POLYMEREN UND HYDROPHOBEN ELASTOMEREN**
LASER ENGRAVABLE FLEXO PRINTING ELEMENTS FOR THE PRODUCTION OF FLEXO PRINTING FORMS CONTAINING BLENDS OF HYDROPHILIC POLYMERS AND HYDROPHOBIC ELASTOMERS
ELEMENTS D'IMPRESSION FLEXOGRAPHIQUE POUVANT ETRE GRAVES AU LASER, SERVANT A LA PRODUCTION DE CLICHES FLEXOGRAPHIQUES CONTENANT DES MELANGES DE POLYMERES HYDROPHILES ET D'ELASTOMERES HYDROPHOBES

(30) Priorität: 27.11.2001 DE 10157769; 22.01.2002 DE 10202441
(43) Veröffentlichungstag der Anmeldung: 01.09.2004
(73) Patentinhaber: Flint Group Germany GmbH, 70469 Stuttgart (DE)
(72) Erfinder: HILLER, Margit, 97753 Karlstadt (DE); SCHADEBRODT, Jens, 55129 Mainz (DE); KACZUN, Jürgen, 67157 Wachenheim (DE); TELSER, Thomas, 69120 Heidelberg (DE); WENZL, Wolfgang, 68167 Mannheim (DE)
(74) Vertreter: Isenbruck, Günter
(86) Internationale Anmeldenummer: PCT/EP2002/012810
(87) Internationale Veröffentlichungsnummer: WO 2003/045693

(56) Entgegenhaltungen:
- EP-A- 0 565 818
- EP-A- 1 136 254
- WO-A-02/49842

## Beschreibung

Die Erfindung betrifft lasergravierbare Flexodruckelemente zur Herstellung von Flexodruckformen, deren Reliefschichten Mischungen aus hydrophilen Polymeren und hydrophoben Elastomeren umfassen. Die Erfindung betrifft weiterhin ein Verfahren zur Herstellung von Flexodruckformen mittels Lasergravur unter Verwendung der besagten Flexodruckelemente.

Bei der Technik der Laser-Direktgravur zur Herstellung von Flexodruckformen wird ein zum Drucken geeignetes Relief direkt in eine dazu geeignete Reliefschicht eingraviert. Durch die Einwirkung der Laserstrahlung werden Schichtbestandteile bzw. deren Abbauprodukte in Form von heißen Gasen, Dämpfen, Rauch, Tröpfchen oder kleinen Partikeln entfernt und dadurch nicht druckende Vertiefungen erzeugt. Die Gravur von Gummidruckzylindern mittels Lasern ist zwar prinzipiell seit Ende der 60er-Jahre des letzten Jahrhunderts bekannt. Breiteres wirtschaftliches Interesse hat diese Technik aber erst in den letzten Jahren mit dem Aufkommen von verbesserten Lasersystemen gewonnen. Zu den Verbesserungen bei den Lasersystemen zählen bessere Fokussierbarkeit des Laserstrahls, höhere Leistung sowie computergesteuerte Strahlführung.

Die Laser-Direktgravur weist gegenüber der konventionellen Herstellung von Flexodruckplatten mehrere Vorteile auf. Eine Reihe von zeitaufwändigen Verfahrensschritten, wie Erstellung eines fotografischen Negativs oder Entwickeln und Trocknen der Druckform, können entfallen. Weiterhin lässt sich die Flankenform der einzelnen Reliefelemente bei der Lasergravur-Technik individuell gestalten. Während bei Photopolymerplatten die Flanken eines Reliefpunktes von der Oberfläche bis zum Reliefgrund kontinuierlich auseinanderlaufen, kann mittels Lasergravur auch eine im oberen Bereich senkrecht oder fast senkrecht abfallende Flanke, die sich erst im unteren Bereich verbreitert, eingraviert werden. Somit kommt es auch mit zunehmender Abnutzung der Platte während des Druckvorganges zu keiner oder allenfalls einer geringen Tonwertzunahme. Weitere Einzelheiten zur Technik der Lasergravur sind bspw. dargestellt in "Technik des Flexodrucks", S. 173 ff., 4. Aufl., 1999, Coating Verlag, St. Gallen, Schweiz.

Zur Herstellung von Flexodruckplatten mittels Lasergravur können prinzipiell handelsübliche fotopolymerisierbare Flexodruckelemente eingesetzt werden. US 5,259,311 offenbart ein Verfahren, bei dem in einem ersten Schritt ein Flexodruckelement durch vollflächige Bestrahlung mittels UV/A fotochemisch vernetzt, danach die release-layer entfernt und in einem zweiten Schritt mittels eines Lasers ein druckendes Relief eingraviert wird. Anschließend erfolgt ein weiterer Reinigungsschritt mittels eines Flexoauswaschmittels und anschließender Trocknung.

EP-A 640 043 und EP-A 640 044 offenbaren einschichtige bzw. mehrschichtige elastomere lasergravierbare Flexodruckelemente zur Herstellung von Flexodruckplatten mittels Lasergravur. Die Elemente bestehen aus "verstärken" elastomeren Schichten. Zur Herstellung der Schicht werden elastomere Bindemittel, insbesondere thermoplastische Elastomere wie bspw. SBS-, SIS- oder SEBS-Blockcopolymere eingesetzt. Durch die so genannte Verstärkung wird die mechanische Festigkeit der Schicht erhöht, um Flexodruck zu ermöglichen. Die Verstärkung wird entweder durch Einbringen geeigneter Füllstoffe, fotochemische oder thermochemische Vernetzung oder Kombinationen davon erreicht.

Der Stand der Technik weist jedoch eine Reihe von Nachteilen auf.

Konventionelle Flexodruckelemente neigen bei der Lasergravur stark dazu, Schmelzränder um die eingravierten Elemente herum zu bilden. Am Rand der eingravierten Elemente schmilzt die Schicht zwar auf, wird aber nicht mehr bzw. nicht mehr vollständig zersetzt. Derartige Schmelzränder führen zu unsauberem Druck und lassen sich auch durch Nachwaschen meist nicht entfernen.

Unerwünschtes Aufschmelzen der Schicht führt weiterhin zu unbefriedigender Auflösung. Bei Verwendung handelsüblicher Flexodruckelemente sind die vom Laser eingravierten Linien in der Praxis meist weitaus breiter als eigentlich erwünscht, so dass beispielsweise zwei dicht benachbarte Vertiefungen in der Reliefschicht (so genannte Negativlinien), die eigentlich durch einen Mittelsteg voneinander getrennt bleiben sollten, zu einer einzigen Vertiefung zusammenfallen.

EP-A 1 136 254 schlägt zur Lösung dieses Problems vor, Reliefschichten mit Polyoxyalkylen/Polyethylenoxid-Pfropfcopolymeren als Bindemittel einzusetzen. Derartige Reliefdruckelemente weisen tatsächlich eine gute Empfindlichkeit gegenüber Laserstrahlung auf und lassen sich mit Lasern gravieren ohne dass Schmelzränder auftreten, die sich nicht mehr entfernen lassen. Die erhaltenen Reliefdruckformen sind aber nachteiligerweise nur in begrenztem Umfange einsetzbar. Da die Polyoxyalkylen/Polyethylenoxid-Pfropfcopolymere wasserlöslich sind, quillt die Reliefschicht in Flexodruckfarben auf Wasserbasis viel zu stark, und es treten beim Drucken unerwünschte Effekte auf, wie bspw. eine nicht mehr tolerierbare Tonwertzunahme. Derartige Druckformen sind im wesentlichen nur mit UV-Druckfarben einsetzbar. Es besteht daher ein dringender Bedarf, auch zum Druck mit Wasserfarben geeignete lasergravierbare Reliefdruckelemente bereitzustellen, die sich dennoch ohne unerwünschtes Aufschmelzen der Schicht mit Lasern gravieren lassen.

Bei der Verwendung handelsüblicher Flexodruckelemente wie von US 5,259,311 vorgeschlagen, bereiten die Abbauprodukte, die im Zuge der Lasergravur entstehen, häufig Probleme. Die nicht gasförmigen Anteile der im Zuge der Lasergravur entstehenden Zersetzungsprodukte sind im Regelfalle äußerst klebrig und können sich ganz oder teilweise wieder auf der Oberfläche des Druckreliefs abscheiden, in ungünstigen Fällen sogar wieder mit der Oberfläche reagieren. Dies führt zu unsauberen Oberflächen und somit auch zu einem schlechten Druckverhalten.

Von US 5,259,311 wird zur Lösung dieses Problems daher vorgeschlagen die Oberfläche der Reliefdruckform nach der Lasergravur mittels eines Lösungsmittels nachzureinigen. Die klebrigen Zersetzungsprodukte weisen jedoch im wesentlichen das gleiche Löslichkeitsverhalten auf wie die Reliefschicht. Für Reliefschichten aus den weit verbreiteten hydrophoben SBS- oder SIS-Blockcopolymeren muss zum Ablösen der Zersetzungsprodukte daher auch ein organisches Lösungsmittel eingesetzt werden. Die vernetzte Reliefschicht ist darin zwar nicht mehr löslich, aber sehr wohl noch quellbar. Im Anschluss an einen derartigen Nachwaschschritt muss die Schicht daher in einem weiteren Verfahrenschritt wieder getrocknet werden. Dadurch wird der durch die Lasergravur erzielte Zeitvorteil im Verfahren wieder zunichte gemacht. Es wäre äußerst wünschenswert, eventuelle Ablagerungen einfach mit Wasser entfernen zu können, ohne dass die Platte dadurch im Übermaße quillt.

Aufgabe der Erfindung war es daher, Flexodruckelemente zur Herstellung von Flexodruckformen mittels Laser-Direktgravur bereitzustellen, die auch zum Drucken mit Flexodruckfarben auf Wasserbasis geeignet sind, bei denen das Auftreten von Schmelzrändern deutlich vermindert ist und eventuelle Ablagerungen von Zersetzungsprodukten durch einfaches Behandeln mit Wasser entfernt werden können.

Dementsprechend wurde in einer ersten Ausführungsform der Erfindung ein lasergravierbares Flexodruckelement gefunden, welches mindestens umfasst:
- einen dimensionsstabilen Träger,
- eine lasergravierbare elastomere, vernetzte reliefbildende Schicht,
erhältlich durch vollflächiges Vernetzen einer vernetzbaren reliefbildenden Schicht die mindestens zwei polymere Bindemittel sowie Komponenten zum Vernetzen umfasst,
wobei es sich bei den mindestens zwei polymeren Bindemitteln um eine Mischung aus mindestens einem hydrophilen Polymer und mindestens einem hydrophoben Elastomer handelt und das Gewichtsverhältnis von hydrophilem Polymer zu hydrophobem Elastomer 1:99 bis 30:70 beträgt, wobei mittels Emulsionspolymerisation hergestellte hydrophile Polymere ausgeschlossen sind, wobei das mindestens eine hydrophile Polymer ein Polyoxyalkylen/Polyvinylalkohol-Propfcopolymer ist.

Überraschenderweise und selbst für den Fachmann unerwartet war es, dass schon die Verwendung von Mischungen mit geringen Anteilen von hydrophilen Polymeren das Auftreten von Schmelzrändern weitgehend unterdrückt und die Auflösung der Druckform deutlich verbessert wird. Reste von Zersetzungsprodukten können problemlos mit Wasser bzw. wässrigen oder Wasser enthaltenden Reinigungsmitteln abgewaschen werden. Die erhaltenen Flexodruckformen eignen sich hervorragend zum Drucken mit Wasserfarben.

Zu der Erfindung ist im Einzelnen das Folgende auszuführen:
Unter dem Begriff "lasergravierbar" ist zu verstehen, dass die Reliefschicht die Eigenschaft besitzt, Laserstrahlung, insbesondere die Strahlung eines IR-Lasers, zu absorbieren, so dass sie an solchen Stellen, an denen sie einem Laserstrahl ausreichender Intensität ausgesetzt ist, entfernt oder zumindest abgelöst wird. Vorzugsweise wird die Schicht dabei ohne vorher zu schmelzen verdampft oder thermisch oder oxidativ zersetzt, so dass ihre Zersetzungsprodukte in Form von heißen Gasen, Dämpfen, Rauch oder kleinen Partikeln von der Schicht entfernt werden.

Beispiele geeigneter dimensionsstabiler Träger für die Flexodruckelemente sind Platten, Folien sowie konische und zylindrische Röhren (sleeves) aus Metallen wie Stahl, Aluminium, Kupfer oder Nickel oder aus Kunststoffen wie Polyethylenterephthalat (PET), Polyethylennaphthalat (PEN), Polybutylenterephthalat, Polyamid, Polycarbonat, gegebenenfalls auch Gewebe und Vliese, wie Glasfasergewebe sowie Verbundmaterialien, z.B. aus Glasfasern und Kunststoffen. Als dimensionsstabile Träger kommen vor allem dimensionsstabile Trägerfolien wie beispielsweise Polyesterfolien, insbesondere PET- oder PEN-Folien oder flexible metallische Träger, wie dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht.

Das erfindungsgemäße, lasergravierbare Flexodruckelement umfasst weiterhin mindestens eine lasergravierbare, elastomere und vernetzte reliefbildende Schicht. Die vernetzte reliefbildende Schicht kann unmittelbar auf dem Träger aufgebracht sein. Zwischen dem Träger und der lasergravierbaren reliefbildenden Schicht können sich aber auch noch andere Schichten befinden, wie beispielsweise Haftschichten und/oder elastische Unterschichten.

Die vernetzte reliefbildende Schicht ist erhältlich durch vollflächiges Vernetzen einer vernetzbaren reliefbildenden Schicht. Die vernetzbare reliefbildende Schicht umfasst mindestens zwei polymere Bindemittel sowie Komponenten zum Vernetzen. Bei Komponenten zum Vernetzen kann es sich um polymerisierbare Monomere oder Oligomere handeln. Es kann sich dabei aber auch um vernetzbare Gruppen handeln, die -ketten-, seiten- und/oder endständigmit dem Bindemittels verknüpft bzw. in das Bindemittel eingebaut sind. Selbstverständlich kann die Schicht sowohl ein vernetzende Gruppen aufweisendes Bindemittel und zusätzlich Monomere enthalten. Komponenten zum Vernetzen umfassen weiterhin Verbindungen, die Vernetzungsreaktionen auslösen können, wie beispielsweise Initiatoren. Im Regelfalle weist die Schicht bereits vor der Vernetzung elastomere Eigenschaften auf, die reliefbildende Schicht kann aber auch vorher nicht elastomer sein und erst durch das Vernetzen elastomer werden.

Bei den mindestens zwei Bindemitteln handelt es sich um eine Mischung aus mindestens einem hydrophilen Polymer und mindestens einem hydrophoben Elastomer. Unter "hydrophil" soll verstanden werden, dass das betreffende Polymer vorzugsweise in Wasser und/oder in schwachen wässrigen Basen mit pH-Werten zwischen 7 und 11 löslich oder zumindest dispergierbar ist. Bei der Mischung handelt es sich im Regelfalle um eine heterogene Mischung d.h. die hydrophobe und die hydrophile Phase sind im mikroskopischen Maßstab unterscheidbar (Begriffsdefinition siehe bspw. Saechtling, Kunststofftaschenbuch, 26. Ausgabe, Hanser Verlag, München Wien, 1995, S.51/52).

In der ersten Ausführungsform der Erfindung können prinzipiell beliebige hydrophile Polymere eingesetzt werden, wobei mittels Emulsionspolymerisation hergestellte hydrophile Polymere ausgeschlossen sind.

Bei den hydrophilen Polymeren handelt es sich um Pfropfcopolymere. Die Polymere weisen hydrophile Gruppen auf. Im Regelfalle sind die hydrophilen Polymere bei der ersten Ausführungsform der Erfindung nicht bzw. im wesentlichen nicht vernetzt.

Selbstverständlich müssen nicht alle monomeren Einheiten, aus denen das hydrophile Polymer aufgebaut ist, hydrophile Gruppen aufweisen. Es ist ausreichend, dass das Polymer hydrophile Gruppen in einer solchen Anzahl aufweist, dass das Polymer als Ganzes die gewünschten hydrophilen Eigenschaften aufweist. Es versteht sich für den Fachmann von selbst, dass im Falle besonders stark hydrophiler Gruppen wie beispielsweise -OH weniger Gruppen am Polymer ausreichend sind, um die gewünschten hydrophilen Eigenschaften des Polymers zu erreichen, während bei Gruppen, deren hydrophile Eigenschaften weniger stark ausgeprägt sind, eine größere Anzahl erforderlich ist.

Die Menge des hydrophilen Polymers in der Reliefschicht wird vom Fachmann je nach den gewünschten Eigenschaften der Reliefschicht gewählt. Will der Fachmann nur wenig hydrophiles Polymer einsetzen, so wird er im allgemeinen ein sehr stark hydrophiles Polymer einsetzen. Will er hingegen eine größere Menge einsetzen, so kann auch ein weniger stark hydrophiles Polymer eingesetzt werden. Besonders vorteilhaft können durch Art und Menge des hydrophilen Polymers außerdem die Oberflächeneigenschaften der Druckform wie bspw. das Farbannahmeverhalten beeinflusst werden.

Das Gewichtsverhältnis von hydrophilem Polymer zu hydrophobem Elastomer in der Reliefschicht beträgt 1:99 bis 30:70, bevorzugt 2:98 bis 20:80 und besonders bevorzugt 3:97 bis 15:85.

Weiterhin sollten Art und Menge des hydrophilen Polymers in der Reliefschicht so bemessen werden, dass die Quellbarkeit der vernetzten Reliefschicht in Wasser bei pH 9 nicht mehr als 5 % beträgt, auch wenn im Einzelfalle für Spezialanwendungen eine höhere Quellbarkeit akzeptabel sein kann. Bevorzugt ist die Quellbarkeit nicht größer als 4% und besonders bevorzugt nicht größer als 3 %. Die Quellbarkeit wird durch einen Quelltest bestimmt, bei dem man die fertige, vernetzte Flexodruckplatte 24 h in einer wässrige Base (Ammoniak) von pH 9 quellen lässt und danach die Gewichtszunahme bestimmt.

Das Molekulargewicht des hydrophilen Polymers kann vom Fachmann je nach den gewünschten Schichteigenschaften festgelegt werden. Im allgemeinen ist es bevorzugt, hydrophile Polymere mit einem Molekulargewicht Mₙ (Zahlenmittel) zwischen 5000 und 200 000 g/mol, bevorzugt 10000 bis 100000 g/mol einzusetzen, ohne dass die Erfindung darauf beschränkt sein soll.

Geeignete hydrophile Polymere sind Polyoxyalkylen/Polyvinyl-alkohol-Pfropfcopolymere, insbesondere Polyoxyethylen/Polyvinyl-alkohol-Pfropfcopolymere. Sie können durch Polymerisation von Vinylestern in Gegenwart von Polyalkylenoxiden und einem radikalischen Polymerisationsinitiator, gefolgt von einer zweiten Reaktionsstufe, in der die Estergruppen zumindest teilweise zu Vinylalkohol-Struktureinheiten verseift werden, hergestellt werden. Im Zuge dieses Prozesses kommt es bevorzugt zu einer Pfropfung der Vinylestereinheiten auf die Polyalkylenoxide. Es sind jedoch auch andere Mechanismen als Pfropfung vorstellbar.Unter Polyoxyalkylen/Polyvinylalkohol-Pfropfcopolymeren sind daher sowohl reine Pfropfcopolymere als auch Mischungen von Pfropfcopolymeren mit Resten von ungepfropften Polyalkylenoxiden sowie zumindest teilweise verseifter Polyvinylester zu verstehen. Polyoxyalkylen/Polyvinylalkohol-Pfropfcopolymere sind prinzipiell bekannt. Ihre Herstellung und Eigenschaften sind in EP-A 1 136 154 Abschnitt [0018] bis Abschnitt [0029] offenbart. Bei der zweiten Komponente der Mischung handelt es sich um ein hydrophobes Elastomer. Geeignet sind vor allem solche Elastomere, die üblicherweise zur Herstellung organisch entwickelbarer, konventioneller Flexodruckplatten eingesetzt werden und die in Wasser weder löslich noch quellbar sind. Als Beispiele seien Naturkautschuk, Polybutadien, Polyisopren, Styrol-Butadien-Kautschuk, Nitril-Butadien-Kautschuk, Butyl-Kautschuk, Styrol-Isopren-Kautschuk, Polynorbornen-Kautschuk oder Ethylen-Propylen-DienKautschuk (EPDM) genannt. Weitere Beispiele umfassen Acrylat-Kautschuke, wie beispielsweise solche auf Basis von n-Butylacrylat oder 2-Ethylhexylacrylat, Ethylen-Acrylat-Kautschuke oder auch Ethylen-Vinylacetat-Kautschuke.

Bevorzugt handelt es sich bei dem hydrophoben Elastomer um ein hydrophobes, thermoplastisch elastomeres Blockcopolymeres aus Alkenylaromaten und 1,3-Dienen. Bei den Blockcopolymeren kann es sich sowohl um lineare Blockcopolymere als auch um radiale Blockcopolymere handeln. Üblicherweise handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymerer eingesetzt werden. Handelsübliche Dreiblockcopolymere enthalten häufig gewisse Anteile an Zweiblockcopolymeren. Die Dien-Einheiten können 1,2- oder 1,4-verknüpft sein. Es können sowohl Blockcopolymere vom Styrol-Butadien wie vom Styrol-Isopren-Typ eingesetzt werden. Sie sind beispielsweise unter dem Namen Kraton^{®} im Handel erhältlich. Weiterhin einsetzbar sind auch thermoplastisch elastomere Blockcopolymere mit Endblöcken aus Styrol und einem statistischen Styrol-Butadien-Mittelblock, die unter dem Namen Styroflex^{®} erhältlich sind. Die Blockcopolymere können auch ganz oder teilweise hydriert sein, wie beispielsweise in SEBS-Kautschuken.

Die Menge der Mischung in der Reliefschicht wird vom Fachmann je nach den gewünschten Eigenschaften der Schicht sowie der gewünschten Vernetzungsmethode bestimmt. Im Regelfalle beträgt die Menge der Mischung 40 bis 95 Gew.-% bezüglich der Menge aller Bestandteile der lasergravierbaren Reliefschicht. Bevorzugt beträgt die Menge der Mischung 50 bis 80 Gew.-% und ganz besonders bevorzugt 55 bis 75 Gew.-%.

Art und Menge der Komponenten zur Vernetzung der Schicht richten sich nach der gewünschten Vernetzungstechnik und werden vom Fachmann entsprechend ausgewählt. Bevorzugt wird die vollflächige Vernetzung der vernetzbaren reliefbildenden Schicht fotochemisch, thermochemisch oder mittels Elektronenstrahlung vorgenommen. Im Falle fotochemischer Vernetzung, umfasst die vernetzbare reliefbildende Schicht mindestens einen Fotoinitiator oder ein Fotoinitiatorsystem. Als Initiatoren für die Fotopolymerisation sind in bekannter Art und Weise Benzoin oder Benzoinderivate, wie α-Methylbenzoin oder Benzoinether, Benzilderivate, wie z.B. Benzilketale, Acylarylphosphinoxide, Acylarylphosphinsäureester, Mehrkernchinone geeignet, ohne dass die Aufzählung darauf beschränkt sein soll. Verfügt die eingesetzte Mischung in ausreichendem Maße über vernetzbare Gruppen, so ist der Zusatz von zusätzlichen vernetzbaren Monomeren oder Oligomeren nicht erforderlich. Im Regelfalle werden zur fotochemischen Vernetzung aber weitere polymerisierbare Verbindungen beziehungsweise Monomere zugegeben. Die Monomere weisen mindestens eine polymerisierbare, olefinisch ungesättigte Gruppe auf. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Styrol oder substituierte Styrole, Ester der Fumar- oder Maleinsäure oder Allylverbindungen erwiesen. Beispiele für geeignete Monomere umfassen Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantriacrylat, Dioctylfumarat, N-Dodecylmaleimid. Es können auch geeignete Oligomere mit olefinischen Gruppen eingesetzt werden. Selbstverständlich können auch Mischungen verschiedener Monomerer bzw. Oligomerer eingesetzt werden, vorausgesetzt es treten keine unerwünschten Eigenschaften auf. Die Gesamtmenge eventuell eingesetzter Monomerer wird vom Fachmann je nach den gewünschten Eigenschaften der Reliefschicht festgelegt. Im Regelfalle sollten aber 30 Gew.-% bezüglich der Menge aller Bestandteile der lasergravierbaren Reliefschicht nicht überschritten werden.

Thermische Vernetzung kann einerseits in Analogie zu der fotochemischen Vernetzung vorgenommen werden, indem statt eines Fotoinitiators ein thermischer Polymerisationsinitiator eingesetzt wird. Als Polymerisationsinitiatoren können prinzipiell handelsübliche thermische Initiatoren für die radikalische Polymerisation eingesetzt werden, wie beispielsweise geeignete Peroxide, Hydroperoxide oder Azoverbindungen. Die thermische Vernetzung kann weiterhin durchgeführt werden, indem man der Schicht ein thermisch härtendes Harz wie beispielsweise ein Epoxyharz als vernetzende Komponente zusetzt.

Vernetzung mittels Elektronenstrahlung kann einerseits in Analogie zur fotochemischen Vernetzung durchgeführt werden, indem die bereits geschilderten fotochemisch vernetzbare Reliefschichten eingesetzt werden und die UV-Strahlung durch Elektronenstrahlung ersetzt wird. Der Zusatz von Initiatoren ist dabei nicht unbedingt erforderlich. Durch Elektronenstrahlung können Polymere, die mittels Elektronenstrahlung vernetzende Gruppen aufweisen, auch direkt, ohne den Zusatz weiterer Monomerer vernetzt werden. Derartige Gruppen umfassen insbesondere olefinische Gruppen oder auch protische Gruppen wie beispielsweise -OH, -NH₂, -NHR, -COOH oder -SO₃H. Es können auch zusätzlich protische Gruppen aufweisende Verbindungen eingesetzt werden. Beispiele umfassen di- oder polyfunktinonelle Monomere eingesetzt werden, bei denen endständige funktionelle Gruppen über einen Spacer miteinander verbunden sind, wie Dialkohole wie beispielweise 1,4-Butandiol, 1,6-Hexandiol, 1,8-Octandiol, 1,9-Nonandiol, Diamine wie beispielsweise 1,6-Hexandiamin, 1,8-Hexandiamin, Dicarbonsäuren wie beispielsweise 1,6-Hexandicarbonsäure, Terephthalsäure, Maleinsäure oder Fumarsäure.

Die vernetzbare reliefbildende Schicht kann weiterhin optional einen Absorber für Laserstrahlung umfassen. Es können auch Gemische verschiedener Absorber für Laserstrahlung eingesetzt werden. Geeignete Absorber für Laserstrahlung weisen eine hohe Absorption im Bereich der Laserwellenlänge auf. Insbesondere sind Absorber geeignet, die eine hohe Absorption im nahen Infrarot sowie im längerwelligen VIS-Bereich des elektromagnetischen Spektrums aufweisen. Derartige Absorber eignen sich besonders zur Absorption der Strahlung von Nd-YAG-Lasern (1064 nm) sowie von IR-Diodenlasern, die typischerweise Wellenlängen zwischen 700 und 900 nm sowie zwischen 1200 und 1600 nm aufweisen.

Beispiele für geeignete Absorber für die Laserstrahlung sind im infraroten Spektralbereich stark absorbierende Farbstoffe wie beispielsweise Phthalocyanine, Naphthalocyanine, Cyanine, Chinone, Metall-Komplex-Farbstoffe wie beispielsweise Dithiolene oder photochrome Farbstoffe. Weiterhin geeignete Absorber sind anorganische Pigmente, insbesondere intensiv gefärbte anorganische Pigmente wie beispielsweise Chromoxide, Eisenoxide, Ruß oder metallische Partikel. Besonders geeignet als Absorber für Laserstrahlung sind feinteilige Rußsorten mit einer Partikelgröße zwischen 10 und 50 nm.

Die Menge des optional zugesetzten Absorbers wird vom Fachmann je nach den jeweils gewünschten Eigenschaften des lasergravierbaren Flexodruckelementes gewählt. In diesem Zusammenhang wird der Fachmann berücksichtigen, dass die zugesetzten Absorber nicht nur Geschwindigkeit und Effizienz der Gravur der elastomeren Schicht durch Laser beeinflussen, sondern auch andere Eigenschaften des als Endprodukt des Verfahrens erhaltenen Reliefdruckform wie beispielsweise dessen Härte, Elastizität, Wärmeleitfähigkeit oder Farbübertragungsverhalten. Im Regelfalle empfiehlt es sich daher, nicht mehr als maximal 20 Gew.-%, bevorzugt nicht mehr als 10 Gew.-% an Absorber für die Laserstrahlung einzusetzen.

Im Regelfalle empfiehlt es sich nicht, Reliefsschichten, die fotochemisch vernetzt werden sollen, Absorber für Laserstrahlung zuzusetzen, die auch im UV-Bereich absorbieren, da dadurch die Fotopolymerisation stark beeinträchtigt wird.

Der vernetzbaren reliefbildenden Schicht kann optional auch ein Weichmacher zugesetzt werden. Es können auch mehrere Weichmacher eingesetzt werden. Beispielsweise können zwei Weichmacher eingesetzt werden, wobei der eine besonders auf die hydrophobe Komponente der Mischung und der andere besonders auf die hydrophile Komponente der Mischung abgestimmt ist.

Beispiele für geeignete Weichmacher insbesondere für die hydrophobe Komponente der Mischung umfassen paraffinische Mineralöle; Ester von Dicarbonsäuren wie Dioctyladipat oder Terephthalsäuredioctylester; naphthenische Weichmacher oder Polybutadienöle mit einem Molgewicht zwischen 500 und 5000 g/mol. Geeignete Weichmacher insbesondere für die hydrophile Komponente der Mischung umfassen hochsiedende Alkohole wie beispielsweise Glycerin oder Polyoxyalkylene wie bspw. Polyethylenglykole. Die Menge an Weichmacher in der vernetzbaren reliefbildenden Schicht wird vom Fachmann je nach der verwendeten Mischung und der gewünschten Härte der Druckplatte gewählt. Im Regelfalle beträgt die Menge aller Weichmacher in der Schicht, 0 bis 30 Gew.-%, bevorzugt 0 bis 20 Gew.-% bezüglich der Summe aller Bestandteile der Schicht.

Die Reliefschichten können weiterhin auch noch Zusatzstoffe und Hilfsstoffe wie beispielsweise Farbstoffe, Dispergierhilfsmittel, Antistatika, abrasive Partikel umfassen. Die Menge derartiger Zusätze sollte im Regelfalle aber 5 Gew.-% bezüglich der Menge aller Komponenten der vernetzbaren, lasergravierbaren Schicht des Aufzeichnungselementes nicht überschreiten.

Die vernetzbare reliefbildende Schicht kann auch aus mehreren Teilschichten aufgebaut werden. Diese vernetzbaren Teilschichten können von gleicher, in etwa gleicher oder von unterschiedlicher stofflicher Zusammensetzung sein. Ein derartiger mehrschichtiger Aufbau, besonders ein zweischichtiger Aufbau, ist manchmal vorteilhaft, weil dadurch Oberflächeneigenschaften und Schichteigenschaften unabhängig voneinander verändert werden können, um ein optimales Druckergebnis zu erreichen. Das lasergravierbare Flexodruckelement kann beispielsweise eine dünne lasergravierbare Oberschicht aufweisen, deren Zusammensetzung im Hinblick auf optimale Farbübertragung ausgewählt wurde, während die Zusammensetzung der darunter liegenden Schicht im Hinblick auf optimale Härte oder Elastizität ausgewählt wurde.

Für die Qualität der lasergravierbaren reliefbildenden Schicht ist eine gute Vermischung der beiden Komponenten der Mischung erforderlich. Zur Unterstützung der gleichmäßigen Vermischung der beiden Komponenten der Mischung können geeignete Dispergierhilfsmittel oder Verträglichkeitsvermittler zugegeben werden. Die vernetzbare reliefbildende Schicht kann prinzipiell durch Lösen bzw.

Dispergieren aller Komponenten in einem geeigneten Lösemittel und Aufgießen auf einen Träger hergestellt werden. Bei Verwendung von Lösemitteln werden bevorzugt das hydrophobe Elastomer und die weiteren Bestandteile der Schicht in einem dazu geeigneten organischen Lösemittel gelöst und das hydrophile Polymer bzw. hydrophile Emulsionscopolymer unter Verwendung eines geeigneten Dispergieraggregates dispergiert. Beispiele geeigneter Dispergieraggregate umfassen Kugelmühlen, Dissolver, Schüttelmaschinen, Extruder oder Walzen. Bei mehrschichtigen Elementen können in prinzipiell bekannter Art und Weise mehrere Schichten aufeinander gegossen werden. Alternativ können beispielsweise die Einzelschichten auf temporäre Träger gegossen und die Schichten anschließend durch Kaschieren miteinander verbunden werden. Bevorzugt wird bei der Herstellung der vernetzbaren reliefbildenden Schicht aber ohne Lösungsmittel gearbeitet und die beiden Komponenten der Mischung sowie die weiteren Bestandteile der Schicht werden in geeigneten Mischaggregaten, wie beispielsweise Knetern, Extrudern oder Walzenstühlen intensiv miteinander vermischt und anschließend zu einer Schicht ausgeformt.

Wird ein elastomeres Bindemittel als hydrophobe Komponente der Mischung eingesetzt, welches nicht thermoplastisch ist, so empfiehlt sich laminares Mischen, beispielsweise mittels eines Walzenstuhles.

Werden thermoplastisch elastomere Bindemitteln als hydrophobe Komponente der Mischung eingesetzt, wird bevorzugt aus den Bestandteilen der Schicht eine homogene Schmelze erzeugt, die anschließend in prinzipiell bekannter Art und Weise mittels Extrusion und anschließender Kalandrierung zu einer vernetzbaren reliefbildenden Schicht ausgeformt werden kann.

Ganz besonders hat sich eine Vorgehensweise bewährt, bei der zunächst die hydrophile Komponente der Mischung mit einem Teil der weiteren Bestandteile der vernetzbaren reliefbildenden Schicht wie Monomeren, Hilfsmitteln sowie ggf. einem Weichmacher intensiv vorgemischt und zu einer homogenen hydrophilen Zusammensetzung verarbeitet wird. Getrennt davon werden das hydrophobe thermoplastische Elastomer mit dem verbleibenden Rest der Schichtbestandteile sowie ggf. einem Weichmacher für die hydrophobe Komponente bei erhöhten Temperaturen in einem geeigneten Mischaggregat zu einer homogenen Schmelze verarbeitet. Die Schmelze wird danach mit der vorhomogenisierten hydrophilen Zusammensetzung vereinigt und zu einer homogenen Schmelze verarbeitet. Mit dieser Vorgehensweise werden qualitativ hochwertige Mischungen in kurzer Zeit erhalten. Bewährt hat sich weiterhin eine Vorgehensweise, alle Bestandteile der Reliefschicht mit der hydrophilen Komponente vorzumischen und dann die hydrophobe Komponente in diese Mischung einzutragen. Die vollflächige Vernetzung der vernetzbaren reliefbildenden Schicht kann fotochemisch insbesondere durch Bestrahlung mit UV-A-Strahlung mit einer Wellenlänge zwischen 320 und 400 nm, bzw. UV-A/VIS-Strahlung mit einer Wellenlänge von 320 bis ca. 700 nm vorgenommen werden. Vollflächige thermochemische Vernetzung erfolgt durch möglichst gleichmäßiges, temperaturkonstantes Erwärmen der Reliefschicht. Weiterhin kann durch gleichmäßige Bestrahlung mit Elektronenstrahlen vernetzt werden. Besonders vorteilhaft kann die zur Vernetzung erforderliche Strahlendosis auf mehrere Teildosen aufgeteilt werden.

Die fotochemische Vernetzung eignet sich insbesondere für im UV/VIS-Bereich transparente vernetzbare reliefbildende Schichten die keine stark gefärbten Absorber für Laserstrahlung enthalten. Transparente vernetzbare reliefbildende Schichten können aber selbstverständlich auch thermochemisch oder mittels Elektronenstrahlung vernetzt werden. Gefärbte Laserabsorber enthaltende vernetzbare reliefbildende Schichten können vorteilhaft thermochemisch oder mittels Elektronenstrahlung vernetzt werden. Die Dicke der lasergravierbaren, elastomeren vernetzten reliefbildenden Schicht bzw. aller Reliefschichten zusammen beträgt im Regelfalle zwischen 0,1 und 7 mm. Die Dicke wird vom Fachmann je nach dem gewünschten Verwendungszweck der Flexodruckform geeignet gewählt.

Bevorzugt beträgt die Dicke 0,3 bis 7 mm, besonders bevorzugt 0,5 bis 5 mm und ganz besonders bevorzugt 0,7 bis 4 mm. Die Dicke wird vom Fachmann je nach dem gewünschten Verwendungszweck der Flexodruckform geeignet gewählt.

Das erfindungsgemäße, lasergravierbare Flexodruckelement kann neben der lasergravierbaren, elastomeren vernetzten Reliefschicht optional weitere Schichten umfassen.

Beispiele derartiger Schichten umfassen eine elastomere Unterschicht aus einer anderen Formulierung, die sich zwischen dem Träger und der bzw. den lasergravierbaren Schicht(en) befindet und die nicht notwendigerweise lasergravierbar sein muss. Mit derartigen Unterschichten können die mechanischen Eigenschaften der Reliefdruckplatten verändert werden, ohne die Eigenschaften der eigentlichen druckenden Reliefschicht zu beeinflussen.

Dem gleichen Zweck dienen so genannte elastische Unterbauten, die sich unter dem dimensionsstabilen Träger des lasergravierbaren Flexodruckelementes befinden, also auf der entgegengesetzten Seite zur lasergravierbaren Schicht.

Weitere Beispiele umfassen Haftschichten, die den Träger mit darüber liegenden Schichten oder verschiedene Schichten untereinander verbinden.

Des Weiteren kann das lasergravierbare Flexodruckelement gegen mechanische Beschädigung durch eine, beispielsweise aus PET bestehende Schutzfolie geschützt werden, die sich auf der jeweils obersten Schicht befindet, und die jeweils vor dem Gravieren mit Lasern entfernt werden muss. Die Schutzfolie kann zur Erleichterung des Abziehens auch silikonisiert oder mit einer geeigneten Entklebeschicht versehen werden.

Das erfindungsgemäße, lasergravierbare Flexodruckelement mit einer elastomeren, vernetzten reliefbildenden Schicht wird als Ausgangsmaterial zur Herstellung einer Druckform mittels Lasergravur verwendet. Hierzu wird mittels eines Lasers ein druckendes Relief in die vernetzte reliefbildende Schicht eingraviert. Falls eine Schutzfolie vorhanden ist, wird diese vor der Gravur abgezogen.

Zur Gravur eigenen sich insbesondere IR-Laser. Beispielsweise kann ein CO₂-Laser mit einer Wellenlänge von 10,6 ∝m eingesetzt werden. Weiterhin können Nd-YAG-Laser (1064 nm), IR-Diodenlaser oder Festkörperlaser eingesetzt werden. Es können auch Laser mit kürzeren Wellenlängen eingesetzt werden, vorausgesetzt der Laser weist eine ausreichende Intensität auf. Beispielsweise kann auch ein frequenzverdoppelter (532 nm) oder frequenzverdreifachter (355 nm) Nd-YAG-Laser eingesetzt werden oder auch Excimer-Laser (z.B. 248 nm).

Der Zusatz von Absorbern für Laserstrahlung richtet sich im wesentlichen nach dem Lasertyp, der zur Gravur eingesetzt werden soll. Die für die Reliefschicht eingesetzten Bindemittel absorbieren die Strahlung von CO₂-Lasern üblicherweise in ausreichendem Maße, so dass bei Verwendung dieses Lasertyps zusätzliche IR-Absorber in der Reliefschicht im Regelfalle nicht erforderlich sind. Das gleiche gilt für UV-Laser, wie bspw. Excimer-Laser. Bei Nd-YAG-Lasern und IR-Dioden-Lasern ist der Zusatz eines Laserabsorbers im Regelfalle erforderlich um wirtschaftlich arbeiten zu können.

Die einzugravierende Bildinformation kann direkt aus den Lay-Out-Computersystem zur Laserapparatur übertragen werden. Die Laser können entweder kontinuierlich oder gepulst betrieben werden.

Vorteilhaft werden Reliefelemente eingraviert, bei denen die Flanken der Elemente zunächst senkrecht abfallen und sich erst im unteren Bereich verbreitern. Dadurch wird eine gute Versockelung der Reliefpunkte bei dennoch geringer Tonwertzunahme erreicht. Es können aber auch andersartig gestaltete Flanken eingraviert werden.

Bei den erfindungsgemäßen Flexodruckelementen ist die Menge der im Zuge der Lasergravur entstehenden Ablagerungen auf den Flexodruckformen im Vergleich zu Flexodruckformen, deren Reliefschicht nicht die hydrophil / hydrophobe Mischung enthält, deutlich vermindert und in manchen Fällen sogar sehr gering. Derartige Flexodruckfomen können u.U. sogar direkt eingesetzt werden.

Vorteilhaft wird die erhaltene Flexodruckform im Anschluss an die Lasergravur nachgereinigt. In manchen Fällen kann dies durch einfaches Abblasen oder Abbürsten geschehen. Es ist aber bevorzugt, zum Nachreinigen ein flüssiges Reinigungsmittel einzusetzen um auch Polymerbruchstücke vollständig entfernen zu können. Die ist beispielsweise dann besonders zu empfehlen, wenn mit der Flexodruckplatte Lebensmittelverpackungen bedruckt werden sollen, bei denen besonders strenge Anforderungen im Hinblick auf flüchtige Bestandteile gelten.

Die Tiefe der einzugravierenden Elemente richtet sich nach der Gesamtdicke des Reliefs und der Art der einzugravierenden Elemente und wird vom Fachmann je nach den gewünschten Eigenschaften der Druckform bestimmt. Die Tiefe der einzugravierenden Reliefelemente beträgt zumindest 0,03 mm, bevorzugt 0,05 mm - genannt ist hier die Mindesttiefe zwischen einzelnen Rasterpunkten. Druckplatten mit zu geringen Relieftiefen sind für das Drucken mittels Flexodrucktechnik im Regelfalle ungeeignet, weil die Negativelemente mit Druckfarbe vollaufen. Einzelne Negativpunkte sollten üblicherweise größere Tiefen aufweisen; für solche von 0,2 mm Durchmesser ist üblicherweise eine Tiefe von mindestens 0,07 bis 0,08 mm empfehlenswert. Bei weggravierten Flächen empfiehlt sich eine Tiefe von mehr als 0,15 mm, bevorzugt mehr als 0,4 mm. Letzteres ist natürlich nur bei einem entsprechend dickem Relief möglich.

Zum Nachreinigen können Lösungsmittelmischungen eingesetzt werden, die üblicherweise als Auswaschmittel für konventionell hergestellte Flexodruckformen dienen. Beispiele umfassen Auswaschmittel auf Basis hochsiedender, entaromatisierter Erdölfraktionen, wie beispielsweise von EP-A 332 070 offenbart oder auch "Wasser-in-Öl"-Emulsionen, wie von EP-A 463 016 offenbart.

Ganz besonders vorteilhaft kann die Nachreinigung mittels Wasser oder einem wässrigen Reinigungsmittel erfolgen. Wässrige Reinigungsmittel bestehen im wesentlichen aus Wasser und enthalten zur Unterstützung des Reinigungsvorganges Hilfsmittel, wie beispielsweise Tenside. Es können auch Mischungen verwendet werden, die üblicherweise zum Entwickeln konventioneller, wasserentwickelbarer Flexodruckplatten eingesetzt werden.

Überraschenderweise lassen sich mit Wasser oder wässrigen Reinigungsmitteln nicht nur bestimmte Anteile der Zersetzungsprodukte entfernen, sondern sie sind vollständig von den druckenden Flächen entfernbar. Dies gilt sogar für den Fall, dass die eingesetzte Mischung nur geringe Anteile hydrophiler Bindemittel aufweist.

Die Nachreinigung kann beispielsweise durch einfaches Eintauchen oder Abspritzen der Reliefdruckform erfolgen oder aber auch zusätzlich durch mechanische Mittel, wie beispielsweise durch Bürsten unterstützt werden.

Die erhaltenen Flexodruckformen eignen sich besonders zum Drucken mit Wasserfarben, sind aber auch zum Drucken mit lösungsmittelhaltigen Flexodruckfarben auf Alkohol- oder Esterbasis geeignet.

Die folgenden Beispiele sollen die Erfindung näher erläutern.

Für die Beispiele wurden die folgenden Stoffe eingesetzt.

| | |
|---|---|
| Kraton D-1102: | SBS-Blockcopolymer (Kraton Polymers) |
| JSR RB 810: | syndiotaktisches 1,2-Polybutadien (JSR) |
| Alcotex 5-97: | Polyvinylalkohol-Polyethylenoxid-Pfropfcopolymer (Harco) |
| Acronal S 695 P: | Styrol-Butylacrylat-(Meth)acrylamid-Emulsionscopolymer (BASF) |
| Styrofan DS 3538: | Styrol-Butadien-Acrylsäure-Emulsionscopolymer (BASF) |
| Nisso PB B-1000 | Oligomeres Polybutadienöl (Nippon Soda) |
| Polyöl 130 | Oligomeres Polybutadienöl (Degussa-Hüls) |
| Glycerin | Glycerin (Aldrich) |
| Laromer HDDA: | 1,6-Hexandioldiacrylat (BASF) |
| Laromer LR 8830: | Phenylglycidetheracrylat (BASF) |
| Lucirin BDK | Benzildimethylketal (BASF) |
| Kerobit TBK | 2,6-Di-tert.-butyl-p-kresol (Raschig) |

### Beispiel 1

### Herstellung eines hydrophilen, monomerhaltigen Compounds mit PEO/PVA-Pfropfcopolymeren

2,25 kg (45,0 Gew.-%) festes Alcotex 5-97 werden in einem Diosna-Mischer (Typ V25 mit Zerhacker, Fa. Dierks & Söhne GmbH) vorgelegt und nach Einschalten des Mischers für die Dauer von 3 Minuten aufgelockert. Nach der Zugabe von 0,5 kg (10,0 Gew.-%) Glycerin wird für weitere 6 Minuten gemischt. Es stellt sich eine Massetemperatur von 50-55 °C ein. Schließlich wird eine Lösung aus 2,165 kg (43,3 Gew.-%) Laromer LR 8830, 0,06 kg (1,2 Gew.-%) Lucirin BDK und 0,025 kg (0,5 Gew.-%) Kerobit TBK zugesetzt. Nach dem Fortsetzen des Mischvorgangs für 6 Minuten ist die Massetemperatur auf ca. 60 °C angestiegen. Der Mischer wird gestoppt und der Inhalt auf Raumtemperatur abgekühlt. Man erhält 5 kg eines hydrophilen, rieselfähigen Compounds, der nachfolgend als "Hydrophiler Compound nach Beispiel 1" bezeichnet wird.

### Beispiel 2

### Flexodruckelement mit PVA/PEO-Pfropfcopolymer und 1,2-Polybutadien

22,5 g (50,0 Gew.-%) JSR RB 810 und 9,0 g (20,0 Gew.-%) Nisso PB B-1000 werden in einem Labormesskneter (Fa. Haake, 50 ml Fassungsvermögen) bei einer Vorgabetemperatur von 150°C solange geknetet, bis man eine homogene Schmelze erhält (ca. 6-8 Minuten). Anschließend wird eine Lösung aus 1,8 g (4,0 Gew.-%) Laromer HDDA, 0,225 g (0,5 Gew.-%) Lucirin BDK und 0,225 g (0,5 Gew.-%) Kerobit TBK hinzugefügt. Nach ca. 2 Minuten ist wieder eine homogene Schmelze entstanden. Schließlich werden noch 11,25 g (25,0 Gew.-%) des hydrophilen Compounds nach Beispiel 1 unter fortgesetztem Kneten zugegeben. Nach 5-6 Minuten hat sich erneut eine homogene Schmelze gebildet. Es stellt sich eine konstante Massetemperatur von 159°C bei einem Drehmoment von 1,5 Nm ein.

Nach dem Abkühlen auf Raumtemperatur wird die erhaltene Knetmasse aus der Knetkammer entnommen und in ca. 3 bis 5 g große Stücke zerteilt. Die Stücke werden zwischen zwei PET-Folien gleichmäßig angeordnet. Durch Pressen in einer handelsüblichen Kautschukpresse bei einer Temperatur von 160 °C und einem Druck von 200 bar wird eine 1,27 mm dicke Platte hergestellt. Man erhält ein transparentes, flexibles und homogenes Flexodruckelement. Das Verhältnis von hydrophilem Polymer zu hydrophobem Elastomer in der Reliefschicht beträgt 18:82.

### Beispiel 3

### Flexodruckelement mit PVA/PEO-Pfropfcopolymer und 1,2-Polybutadien, Best mode

Es wurde wie in Beispiel 2 vorgegangen, nur wurden 27,0 g (60,0 Gew.-%) JSR RB 810, 9,0 g (20,0 Gew.-%) Nisso PB B-1000, 1,8 g (4,0 Gew.-%) Laromer HDDA, 0,225 g (0,5 Gew.-%) Lucirin BDK, 0,225 g (0,5 Gew.-%) Kerobit TBK sowie 6,75 g (15,0 Gew.-%) des hydrophilen Compounds nach Beispiel 1 eingesetzt.

Man erhält ein transparentes, flexibles und homogenes Flexodruckelement. Das Verhältnis von hydrophilem Polymer zu hydrophobem Elastomer in der Reliefschicht beträgt 10:90.

### Beispiel 4

### Flexodruckelement mit PVA/PEO-Pfropfcopolymer und 1,2-Polybutadien

Es wurde wie in Beispiel 2 vorgegangen, nur wurden 29,25 g (65,0 Gew.-%) JSR RB 810, 9,0 g (20,0 Gew.-%) Nisso PB B-1000, 1,8 g (4,0 Gew.-%) Laromer HDDA, 0,225 g (0,5 Gew.-%) Lucirin BDK, 0,225 g (0,5 Gew.-%) Kerobit TBK sowie 4,5 g (10,0 Gew.-%) des hydrophilen Compounds nach Beispiel 1 eingesetzt.

Man erhält ein transparentes, flexibles und homogenes Flexodruckelement. Das Verhältnis von hydrophilem Polymer zu hydrophobem Elastomer in der Reliefschicht beträgt 7:93.

### Beispiel 5

### Flexodruckelement mit PVA/PEO-Pfropfcopolymer und 1,2-Polybutadien

Es wurde wie in Beispiel 2 vorgegangen, nur wurden 31,5 g (70,0 Gew.-%) JSR RB 810, 9,0 g (20,0 Gew.-%) Nisso PB B-1000, 1,8 g (4,0 Gew.-%) Laromer HDDA, 0,225 g (0,5 Gew.-%) Lucirin BDK, 0,225 g (0,5 Gew.-%) Kerobit TBK sowie 2,25 g (5,0 Gew.-%) des hydrophilen Compounds nach Beispiel 1 eingesetzt.

Man erhält ein transparentes, flexibles und homogenes Flexodruckelement. Das Verhältnis von hydrophilem Polymer zu hydrophobem Elastomer in der Reliefschicht beträgt 3:97.

### Beispiel 6

### Flexodruckelement mit PVA/PEO-Pfropfcopolymer und SBS-Dreiblockcopolymer

Es wurde wie in Beispiel 2 vorgegangen, nur wurden 17,33 g (38,5 Gew.-%) Kraton D-1102, 7,2 g (16,0 Gew.-%) Nisso PB B-1000, 7,2 g (16,0 Gew.-%) Polyöl 130, 4,5 g (10,0 Gew.-%) Laromer HDDA, 0,9 g (2,0 Gew.-%) Lucirin BDK, 0,45 g (1,0 Gew.-%) Kerobit TBK sowie 7,43 g (16,5 Gew.-%) des hydrophilen Compounds nach Beispiel 1 eingesetzt. Am Schluss stellt sich eine konstante Massetemperatur von 160°C bei einem Drehmoment von 0,2 Nm ein.

Man erhält ein leicht opakes, flexibles und homogenes Flexodruckelement. Das Verhältnis von hydrophilem Polymer zu hydrophobem Elastomer in der Reliefschicht beträgt 16:84.

### Referenzbeispiel 7

### Flexodruckelement mit hydrophilem Emulsioncopolymer und SBS-Dreiblockcopolymer

Zunächst stellt man in einem 250 ml Becherglas eine Lösung aus 16,0 g Nisso PB B-1000, 16,0 g Polyöl 130, 10,0 g Laromer HDDA, 2,0 g Lucirin BDK und 1,0 g Kerobit TBK bei 80°C her. Zu der heißen Lösung werden unter manuellem Rühren 16,5 g Acronal S 695 P gegeben. Nach einigen Minuten bildet sich eine teigförmige, homogene Masse, im folgenden als "Acronal-Dispersionscompound" bezeichnet.

17,33 g (38,5 Gew.-%) Kraton D-1102 und 27,67 g (61,5 Gew.-%) des Acronal-Dispersionscompounds werden in einem Labormesskneter (Fa. Haake, 50 ml Fassungsvermögen) bei einer Vorgabetemperatur von 150°C solange geknetet, bis man eine homogene Schmelze erhält (ca. 15 Minuten). Es stellt sich eine konstante Massetemperatur von 160°C bei einem Drehmoment von 0,3 Nm ein.

Die erhaltene Masse wurde wie in Beispiel 2 beschrieben zu einem Flexodruckelement verarbeitet. Man erhält ein leicht opakes, flexibles und homogenes Flexodruckelement. Das Verhältnis von hydrophilem Emulsionscopolymer zu hydrophobem Elastomer in der Reliefschicht beträgt 29:71.

### Referenzbeispiel 8

### Flexodruckelement mit hydrophilem Emulsionscopolymer und SBS-Dreiblockcopolymer

Es wurde wie in Beispiel 7 vorgegangen, nur wurde anstelle von Acronal Styrofan eingesetzt.

Man erhält ein leicht opakes, flexibles und homogenes Flexodruckelement. Das Verhältnis von hydrophilem Emulsionscopolymer zu hydrophobem Elastomer in der Reliefschicht beträgt 29:71.

### Vergleichsbeispiel A

### Flexodruckelement mit 1,2-Polybutadien, keine hydrophile Komponente

33,75 g (75,0 Gew.-%) JSR RB 810 und 9,0 g (20,0 Gew.-%) Nisso PB B-1000 werden in einem Labormesskneter (Fa. Haake, 50 ml Fassungsvermögen) bei einer Vorgabetemperatur von 150°C solange geknetet, bis man eine homogene Schmelze erhält (ca. 6-7 Minuten). Danach wird unter fortgesetztem Kneten eine Lösung aus 1,8 g (4,0 Gew.-%) Laromer HDDA, 0,225 g (0,5 Gew.-%) Lucirin BDK und 0,225 g (0,5 Gew.-%) Kerobit TBK hinzugefügt. Nach ca. 3 Minuten ist wieder eine homogene Schmelze entstanden. Es stellt sich eine konstante Massetemperatur von 164°C bei einem Drehmoment von 1,8 Nm ein.

Aus der abgekühlten und zerteilten Knetmasse wird unter gleichen Bedingungen wie in Beispiel 2 ein transparentes, flexibles und homogenes Flexodruckelement durch Pressen erzeugt.

### Vergleichsbeispiel B

Flexodruckelement mit SBS-Kautschuk, keine hydrophile Komponente 24,75 g (55,0 Gew.-%) Kraton D-1102 und 14,4 g (32,0 Gew.-%) Nisso PB B-1000 werden in einem Labormesskneter (Fa. Haake, 50 ml Fassungsvermögen) bei einer Vorgabetemperatur von 140°C solange geknetet, bis man eine homogene Schmelze erhält (ca. 7-8 Minuten). Danach wird unter fortgesetztem Kneten eine Lösung aus 4,5 g (10,0 Gew.-%) Laromer HDDA, 0,9 g (2,0 Gew.-%) Lucirin BDK und 0,45 g (1,0 Gew.-%) Kerobit TBK hinzugefügt. Nach ca. 6 Minuten ist wieder eine homogene Schmelze entstanden. Es stellt sich eine konstante Massetemperatur von 160°C bei einem Drehmoment von 1,4 Nm ein.

Aus der abgekühlten und zerteilten Knetmasse wird unter gleichen Bedingungen wie in Beispiel 2 ein transparentes, flexibles und homogenes Flexodruckelement durch Pressen erzeugt.

### Vergleichsbeispiel C

### Reliefdruckelement mit PVA/PEO-Pfropfcoolymer, keine hydrophobe Komponente

Es wurde ein Reliefdruckelement gemäß Beispiel 1 von EP-A 1 136 254 hergestellt.

### Fotochemische Vernetzung der vernetzbaren Flexodruckelemente

Alle Flexodruckelemente werden vollflächig fotochemisch vernetzt.

Die fotochemische Vernetzung wird mittels eines nyloflex^{®} F III-Belichters der BASF Drucksysteme GmbH durchgeführt, indem zunächst die transparente PET-Schutzfolie des Flexodruckelements entfernt und die Schicht anschließend für die jeweilige Dauer der Vernetzung mit UVA-Licht vollflächig ohne Vakuum bestrahlt wird.

Von den erhaltenen Flexodruckelementen wird in Anlehnung an DIN 53505 die mechanische Härte mit einem Härtemessgerät Typ U 72/80E, Heinrich Bareiss Prüfgerätebau GmbH, bestimmt, indem die Trägerfolie entfernt, aus mehreren Schichten durch Übereinanderstapeln bis zu einer Gesamtschichtdicke von ca. 6 mm ein Schichtverbund gebildet und dieser Schichtverbund der Härtemessung unterzogen wird.

Die verwendeten Belichtungszeiten, die visuell beurteilte Transparenz der resultierenden, vernetzten Schichten sowie die mechanischen Härtedaten der photochemisch vernetzten, lasergravierbaren Flexodruckelemente sind in Tabelle 1 als Übersicht dargestellt.

**Tabelle 1**

| Beispiel | Belichtungszeit UVA | Transparenz | Mechanische Härte |
|---|---|---|---|
| Nr. | [min] | *(visuell)* | [°Shore A] |
| 2 | 10 | Transparent | 51 |
| 3 | 10 | Transparent | 60 |
| 4 | 10 | Transparent | 63 |
| 5 | 10 | Transparent | 65 |
| 6 | 10 | Leicht opak | 38 |
| 7 | 10 | Leicht opak | 37 |
| 8 | 10 | Leicht opak | 42 |
| A | 10 | Transparent | 69 |
| B | 10 | Transparent | 50 |
| C | 10 | Transparent | 49 |

### Lasergravur der Flexodruckelemente

Für Lasergravurversuche wird ein CO₂-Laser (Fa. ALE, Typ "ALE meridian finesse") mit einem Spotdurchmesser von ca. 30 ∝m und einer Nennleistung von 250 Watt verwendet. Die Leistung auf der Plattenoberfläche betrug bei maximaler Leistung ca. 150 Watt. Die Lasergravurversuche wurden mit den folgenden Software-Parametern durchgeführt: *Total relief* = 75, *First step =* 48, *Engraving Speed =* 240 U/min und *Shoulder base width* = 1,24.

Nach dem Aufspannen des Flexodruckelements auf einen Zylinder wird ein Testmotiv bestehend aus verschiedenen, repräsentativen, positiven und negativen Elementen in das Flexodruckelement eingraviert. Neben vollflächigen 0 %-Tonwerten und 100 %-Tonwerten enthält das Motiv auch 40 ∝m breite Negativlinien in axialer und transversaler Richtung zur Zylinderdrehachse.

Im Anschluss an die Lasergravur werden die erhaltenen Flexodruckformen für zwei Minuten mit Wasser bei gleichzeitigem Bürsten der Oberfläche nachgewaschen. Hierzu wird ein nyloprint^{®}-Wascher (Gerätekombination "CW 22 x 30", BASF Drucksysteme GmbH) verwendet.

Zur Beurteilung der Qualität der Flexodruckformen werden die folgenden Merkmale bestimmt:
- Die Gravurtiefe T als Maß für die Empfindlichkeit, gemessen als Höhendifferenz zwischen einem vollflächig abgetragenen Bereich und der Plattenoberfläche.
- Die tatsächliche Breite Bₜᵣ der 40 ∝m breiten transversalen Negativlinie sowie die Differenz ΔBₜᵣ zwischen der tatsächlichen Breite und der Sollbreite von 40 ∝m als Maß für die Genauigkeit.
- Die tatsächliche Breite Bₐₓ der 40 ∝m breiten axialen Negativlinie sowie die Differenz ΔBₐₓ zwischen der tatsächlichen Breite und der Sollbreite von 40 ∝m als Maß für die Genauigkeit.
- Die visuelle Beurteilung der Bildung von Ablagerungen, Schmelzrändern und klebrigen Tröpfchen ("**A**blagerungen") sowie die visuelle Beurteilung der Abwaschbarkeit von oberflächlichen Ablagerungen ("**A**bwaschbarkeit") beim Nachwaschen mit Wasser.
- Die Quellung Q_{W} der lasergravierten Flexodruckelemente als Maß für die Resistenz gegenüber wässrigen Flexodruckfarben. Die Quellbarkeit wird durch einen Quelltest ermittelt, bei dem ein Stück des vernetzen Reliefdruckelementes für 24 h bei RT in eine wässrigen Base (Ammoniakwasser) mit pH 9 eingetaucht wird. Ermittelt wird die prozentuale Gewichtszunahme der Schicht im Zuge des Tests.

In Tabelle 2 sind die bestimmten Messwerte für alle Beispiele und Vergleichsbeispiele aufgelistet.

| **Beispiel** | **Elastomer** | **Menge** | **hydrophiles Polymer** | **Menge** | **Gravurtiefe** | **Negativlinien** | | | | **Ablagerungen** | **Abwaschbarkeit** | **Quellung** |
|---|---|---|---|---|---|---|---|---|---|---|---|---|
| **Nr.** | | | | | **T [∝m]** | **Bₜᵣ [∝m]** | **ΔBₜᵣ [∝m]** | **Bₐₓ [∝m]** | **ΔBₐₓ [∝m]** | ***(visuell)*** | ***(visuell)*** | **Q_{W} [%]** |
| **2** | syndiotaktisches 1,2 PB | 82 | PVA/PEO | 18 | 810 | 69 | +29 | 39 | -1 | Wenig | **Sehr gut** | 3,6 |
| **3** | syndiotaktisches 1,2 PB | 90 | PVA/PEO | 10 | 760 | 77 | +37 | 41 | +1 | Wenig | **Sehr gut** | 2,2 |
| **4** | syndiotaktisches 1,2 PB | 93 | PVA/PEO | 7 | 870 | 71 | +31 | 49 | +9 | Mittel | **Gut** | 1,6 |
| **5** | syndiotaktisches 1,2 PB | 97 | PVA/PEO | 3 | 720 | 84 | +44 | 55 | +15 | Mittel | **Gut** | 1,0 |
| **6** | SBS | 84 | PVA/PEO | 16 | 730 | 95 | +55 | 66 | +26 | Mittel | **Sehr gut** | 4,2 |
| **7** | SBS | 71 | Acronal | 29 | 690 | 98 | +58 | 78 | +38 | Stark | **Gut** | 0,8 |
| **8** | SBS | 71 | Styrofan | 29 | 700 | 105 | +65 | 71 | +31 | Stark | **Gut** | 1,4 |
| **A** | syndiotaktisches 1,2 PB | 100 | - | - | 690 | 96 | +46 | 64 | +24 | Mittel | **Schlecht** | 0,5 |
| **B** | SBS | 100 | - | - | 660 | 104 | +64 | 76 | +36 | Stark | **Schlecht** | 0,4 |
| **C** | - | - | PVA/PEO | 100 | 600 | 124 | +84 | 68 | +28 | mittel | **sehr gut** | 82 |

Die Menge an hydrophilem Polymer bezieht sich jeweils auf die Gesamtmenge an Polymeren.

Die erfindungsgemäßen lasergravierbaren Flexodruckelemente mit hydrophil/hydrophoben Blends sind lasergravierbaren Flexodruckelementen, die kein Blend als Bindemittel aufweisen, deutlich überlegen.

In allen Fällen können feine Reliefelemente wie die gezeigten Negativlinien in höherer Güte abgebildet werden. Schmelzränder, Laserabraum und abgelagerte Partikel können durch kurze Behandlung mit Wasser vollständig entfernt werden.

Die Flexodruckformen weisen bei einem Quelltest in einer wässrigen Base keine übermäßige Quellung auf.

## Patentansprüche

1. Lasergravierbares Flexodruckelement zur Herstellung von Flexodruckformen mindestens umfassend
- einen dimensionsstabilen Träger,
- eine lasergravierbare elastomere, vernetzte reliefbildende Schicht, erhältlich durch vollflächiges Vernetzen einer vernetzbaren reliefbildenden Schicht, die mindestens zwei polymere Bindemittel sowie Komponenten zum Vernetzen umfasst,
**dadurch gekennzeichnet, dass** es sich bei den mindestens zwei polymeren Bindemitteln um eine Mischung aus mindestens einem hydrophilen Polymer und mindestens einem hydrophoben Elastomer handelt und das Gewichtsverhältnis von hydrophilem Polymer zu hydrophobem Elastomer 1:99 bis 30:70 beträgt, wobei mittels Emulsionspolymerisation hergestellte hydrophile Polymere ausgeschlossen sind, wobei das mindestens eine hydrophile Polymer ein Polyoxy-alkylen/Polyvinylalkohol-Pfropfcopolymer ist.

2. Lasergravierbares Flexodruckelement gemäß Anspruch 1, **dadurch gekennzeichnet, dass** das Gewichtsverhältnis von hydrophilem Polymer zu hydrophobem Elastomer 2:98 bis 20:80 beträgt.

3. Lasergravierbares Flexodruckelement gemäß Anspruch 1 oder 2, **dadurch gekennzeichnet, dass** es sich bei dem hydrophoben Elastomer um ein thermoplastisch elastomeres Blockcopolymers handelt.

4. Lasergravierbares Flexodruckelement gemäß einem der Ansprüche 1 bis 3, **dadurch gekennzeichnet, dass** die reliefbildende Schicht weiterhin mindestens einen Absorber für Laserstrahlung umfasst.

5. Lasergravierbares Flexodruckelement gemäß einem der Ansprüche 1 bis 4, **dadurch gekennzeichnet, dass** die vollflächige Vernetzung der vernetzbaren reliefbildenden Schicht fotochemisch, thermochemisch oder mittels Elektronenstrahlung vorgenommen wird.

6. Verfahren zur Herstellung von Flexodruckformen, bei dem mittels eines Lasers ein Druckrelief in die vernetzte reliefbildende Schicht eines Flexodruckelementes gemäß einem der Ansprüche 1 - 6 eingraviert wird.

7. Verfahren nach Anspruch 6, **dadurch gekennzeichnet, dass** man die Oberfläche der Flexodruckform nach der Lasergravur nachreinigt.

8. Verfahren gemäß Anspruch 7, **dadurch gekennzeichnet, dass** die Nachreinigung mittels Wasser oder einem wässrigen Reinigungsmittel erfolgt.

## Claims

1. A laser-engravable flexographic printing element for the production of flexographic printing plates, at least comprising
- a dimensionally stable substrate,
- a laser-engravable elastomeric, crosslinked relief-forming layer, obtainable by uniform crosslinking of a crosslinkable relief-forming layer which comprises at least two polymeric binders and components for crosslinking,
wherein the at least two polymeric binders comprise a mixture of at least one hydrophilic polymer and at least one hydrophobic elastomer and the weight ratio of hydrophilic polymer to hydrophobic elastomer is from 1:99 to 30:70, hydrophilic polymers prepared by means of emulsion polymerization being excluded, the at least one hydrophilic polymer being a polyoxyalkylene/polyvinyl alcohol graft copolymer.

2. A laser-engravable flexographic printing element according to claim 1, wherein the weight ratio of hydrophilic polymer to hydrophobic elastomer is from 2:98 to 20:80.

3. A laser-engravable flexographic printing element according to claim 1 or 2, wherein the hydrophobic elastomer is a thermoplastic elastomeric block copolymer.

4. A laser-engravable flexographic printing element according to any of claims 1 to 3, wherein the relief-forming layer furthermore comprises at least one absorber for laser radiation.

5. A laser-engravable flexographic printing element according to any of claims 1 to 4, wherein the uniform crosslinking of the crosslinkable relief-forming layer is carried out photochemically, thermochemically or by means of electron beams.

6. A process for the production of flexographic printing plates, in which a printing relief is engraved in the crosslinked relief-forming layer of a flexographic printing element according to any of claims 1 - 6 by means of a laser.

7. The process according to claim 6, wherein the surface of the flexographic printing plate is cleaned after the laser engraving.

8. The process according to claim 7, wherein the subsequent cleaning is effected by means of water or an aqueous cleaning agent.

## Revendications

1. Elément d'impression flexographique pouvant être gravé au laser servant à la production de clichés flexographiques, comprenant au moins
- un support de dimensions stables,
- une couche élastomère réticulée, formant un relief, pouvant être gravée au laser, pouvant être obtenue par réticulation sur toute la surface d'une couche réticulable formant un relief, qui comprend au moins deux liants polymères ainsi que des composants pour la réticulation,
**caractérisé en ce que** lesdits au moins deux liants polymères sont un mélange d'au moins un polymère hydrophile et d'au moins un élastomère hydrophobe et le rapport pondéral du polymère hydrophile à l'élastomère hydrophobe vaut 1:99 à 30:70, dans lequel des polymères hydrophiles produits par polymérisation d'une émulsion sont exclus, dans lequel ledit au moins un polymère hydrophile est un copolymère greffé polyoxyalkylène-alcool polyvinylique.

2. Elément d'impression flexographique pouvant être gravé au laser selon la revendication 1, **caractérisé en ce que** le rapport pondéral du polymère hydrophile à l'élastomère hydrophobe vaut 2:98 à 20:80.

3. Elément d'impression flexographique pouvant être gravé au laser selon la revendication 1 ou 2, **caractérisé en ce que** l'élastomère hydrophobe est un copolymère bloc élastomère thermoplastique.

4. Elément d'impression flexographique pouvant être gravé au laser selon l'une des revendications 1 à 3, **caractérisé en ce que** la couche formant un relief comprend en outre au moins un absorbeur pour le faisceau laser.

5. Elément d'impression flexographique pouvant être gravé au laser selon l'une des revendications 1 à 4, **caractérisé en ce que** la réticulation sur toute la surface de la couche réticulable formant un relief est opérée par voie photochimique, thermochimique ou au moyen d'un faisceau d'électrons.

6. Procédé de production de clichés flexographiques, dans lequel on grave au moyen d'un laser un relief d'impression dans la couche réticulée formant un relief d'un élément d'impression flexographique selon l'une des revendications 1 à 6.

7. Procédé selon la revendication 6, **caractérisé en ce que** l'on nettoie la surface du cliché flexographique après la gravure au laser.

8. Procédé selon la revendication 7, **caractérisé en ce que** l'on effectue le nettoyage au moyen d'eau ou d'un agent de nettoyage aqueux.
